(19) **Europäisches Patentamt / European Patent Office / Office européen des brevets**

(11) **EP 4 722 737 A2**

(12) # EUROPEAN PATENT APPLICATION

(43) Date of publication:
**08.04.2026 Bulletin 2026/15**

(21) Application number: **25204234.6**

(22) Date of filing: **24.09.2025**

(51) International Patent Classification (IPC):
***G01R 15/20*** *(2006.01)*

(52) Cooperative Patent Classification (CPC):
**G01R 15/207**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **02.10.2024 JP 2024172984**

(71) Applicant: **Yokogawa Electric Corporation Tokyo 180-8750 (JP)**

(72) Inventors:
- **SAKAMAKI, Yasuo**
  **Musashino-shi, Tokyo, 180-8750, (JP)**
- **TAKENAKA, Kazuma**
  **Musashino-shi, Tokyo, 180-8750, (JP)**
- **NOGUCHI, Naoki**
  **Musashino-shi, Tokyo, 180-8750, (JP)**
- **TERAO, Minako**
  **Musashino-shi, Tokyo, 180-8750, (JP)**

(74) Representative: **Winter, Brandl - Partnerschaft mbB**
**Alois-Steinecker-Straße 22**
**85354 Freising (DE)**

(54) **ELECTRIC CURRENT SENSOR, ELECTRIC CURRENT MEASUREMENT DEVICE, AND ELECTRIC CURRENT MEASUREMENT METHOD**

(57) An electric current sensor (1) includes a shield (3) having an opening (37) for capturing a magnetic field (H) in the shield (3), the magnetic field (H) having been generated by an electric current (I) flowing through a conductor (9), a magnetic field sensor (4) that is placed at a position in the shield (3) and outputs a sensor voltage corresponding to the magnetic field (H) at the position, and a detection circuit (6) that is placed outside the shield (3) and detects the electric current (I) on the basis of the sensor voltage from the magnetic field sensor (4). The magnetic field sensor (4) includes a first magnetic field sensor (41) to detect low-frequency magnetic fields, and a second magnetic field sensor (42) to detect high-frequency magnetic fields. The first magnetic field sensor (41) is placed nearer to the opening (37) than the second magnetic field sensor (42) and the second magnetic field sensor (42) is placed farther from the opening (37) than the first magnetic field sensor (41).

EP 4 722 737 A2

**Description**

BACKGROUND OF THE INVENTION

1. Field of the Invention

The present disclosure relates to an electric current sensor, an electric current measurement device, and an electric current measurement method.

2. Description of the Related Art

In a method for measuring an electric current flowing through a conductor, a magnetic field generated by that electric current is detected. When higher frequency of the electric current induces the skin effect in the conductor, precision of the detection of the magnetic field may thereby be reduced, and precision of the measurement of the electric current may thus be reduced. For example, in Japanese Unexamined Patent Application Publication No. 2014-115114, subtraction between output signals from two electromagnetic conversion elements is performed to reduce influence of the skin effect.

One may consider covering a conductor with a shield to prevent influence of a magnetic field other than a magnetic field generated by an electric current flowing through the conductor. Measures against the skin effect in using the shield have not been particularly discussed in Japanese Unexamined Patent Application Publication No. 2014-115114.

In one aspect of the present disclosure, reduction in precision of measurement of an electric current is minimized, the reduction being due to the skin effect.

SUMMARY OF THE INVENTION

An electric current sensor according to one aspect of the present disclosure includes a shield having an opening for capturing a magnetic field in the shield, the magnetic field having been generated by an electric current flowing through a conductor, a magnetic field sensor that is placed at a position in the shield and outputs a sensor voltage corresponding to the magnetic field at the position, and a detection circuit that is placed outside the shield and detects the electric current on the basis of the sensor voltage from the magnetic field sensor, wherein the magnetic field sensor includes a first magnetic field sensor to detect low-frequency magnetic fields, and a second magnetic field sensor to detect high-frequency magnetic fields, the first magnetic field sensor is placed nearer to the opening than the second magnetic field sensor, and the second magnetic field sensor is placed farther from the opening than the first magnetic field sensor.

An electric current sensor according to one aspect of the present disclosure includes a shield having an opening for capturing a magnetic field in the shield, the magnetic field having been generated by an electric current flowing through a conductor, a magnetic field sensor that is placed at a position in the shield and outputs a sensor voltage corresponding to the magnetic field at the position, a detection circuit that is placed outside the shield and detects the electric current on the basis of the sensor voltage from the magnetic field sensor, and a movement mechanism that moves the magnetic field sensor, wherein the magnetic field sensor includes a first magnetic field sensor that is placed near the opening and is to detect high-frequency magnetic fields, and a second magnetic field sensor to detect high-frequency magnetic fields, and the movement mechanism moves the second magnetic field sensor between a position near the opening and a position far from the opening.

An electric current measurement device according to one aspect of the present disclosure includes a shield having an opening for capturing a magnetic field in the shield, the magnetic field having been generated by an electric current flowing through a conductor, a magnetic field sensor that is placed at a position in the shield and outputs a sensor voltage corresponding to the magnetic field at the position, a detection circuit that is placed outside the shield and generates, on the basis of the sensor voltage from the magnetic field sensor, a detection voltage indicating a value of the electric current, and an external device that is placed outside the shield and corrects the detection voltage in a frequency domain.

An electric current measurement method according to one aspect of the present disclosure includes detecting a magnetic field at a position by using a magnetic field sensor placed at the position in a shield having an opening for capturing the magnetic field in the shield, the magnetic field having been generated by an electric current flowing through a conductor, and detecting the electric current on the basis of a detection result from the magnetic field sensor, wherein the magnetic field sensor includes a first magnetic field sensor to detect low-frequency magnetic fields, and a second magnetic field sensor to detect high-frequency magnetic fields, the first magnetic field sensor is arranged nearer to the opening than the second magnetic field sensor, and the second magnetic field sensor is arranged farther from the opening than the first magnetic field sensor.

BRIEF DESCRIPTION OF THE DRAWINGS

FIG. 1 is a diagram illustrating an example of a schematic configuration of an electric current measurement device 100 according to an embodiment;
FIG. 2 is a diagram illustrating an example of a schematic configuration of a shield 3;
FIG. 3 is a diagram illustrating an example of a detection circuit 6;
FIG. 4 is a diagram illustrating an example of a schematic configuration of an electric current sensor 1;
FIG. 5 is a diagram illustrating an example of a near region and a far region;
FIG. 6 is a diagram illustrating an example of operation;
FIG. 7 is a diagram illustrating an example of operation;
FIG. 8 is a diagram illustrating an example of frequency characteristics;
FIG. 9 is a flowchart illustrating an example of a process (an electric current measurement method) executed at the electric current sensor 1;
FIG. 10 is a diagram illustrating an example of a schematic configuration of the electric current sensor 1;
FIG. 11 is a diagram illustrating an example of a schematic configuration of the detection circuit 6;
FIG. 12 is a diagram illustrating an example of determinations on whether or not the skin effect is present;
FIG. 13 is a diagram illustrating the example of the determinations on whether or not the skin effect is present;
FIG. 14 is a flowchart illustrating an example of a process (an electric current measurement method) executed at the electric current sensor 1;
FIG. 15 is a diagram illustrating an example of a schematic configuration of the electric current sensor 1;
FIG. 16 is a diagram illustrating an example of a schematic configuration of the detection circuit 6;
FIG. 17 is a flowchart illustrating an example of a process (an electric current measurement method) executed at the electric current sensor 1;
FIG. 18 is a diagram illustrating an example of a schematic configuration of the electric current sensor 1;
FIG. 19 is a diagram illustrating an example of a schematic configuration of the detection circuit 6 and an external device 2;
FIG. 20 is a diagram illustrating an example of a waveform of detection voltage V3 that has not been corrected yet;
FIG. 21 is a diagram illustrating an example of a frequency component of the detection voltage V3, the frequency component not having been corrected yet;
FIG. 22 is a diagram illustrating an example of correction of the frequency component of the detection voltage V3;
FIG. 23 is a diagram illustrating an example of inverse Fourier transform; and
FIG. 24 is a flowchart illustrating an example of a process (an electric current measurement method) executed at the electric current measurement device 100.

DETAILED DESCRIPTION OF THE PREFERRED EMBODIMENTS

Embodiments will hereinafter be described while reference is made to the drawings. The same reference sign will be assigned to elements that are the same and redundant description thereof will be omitted as appropriate.

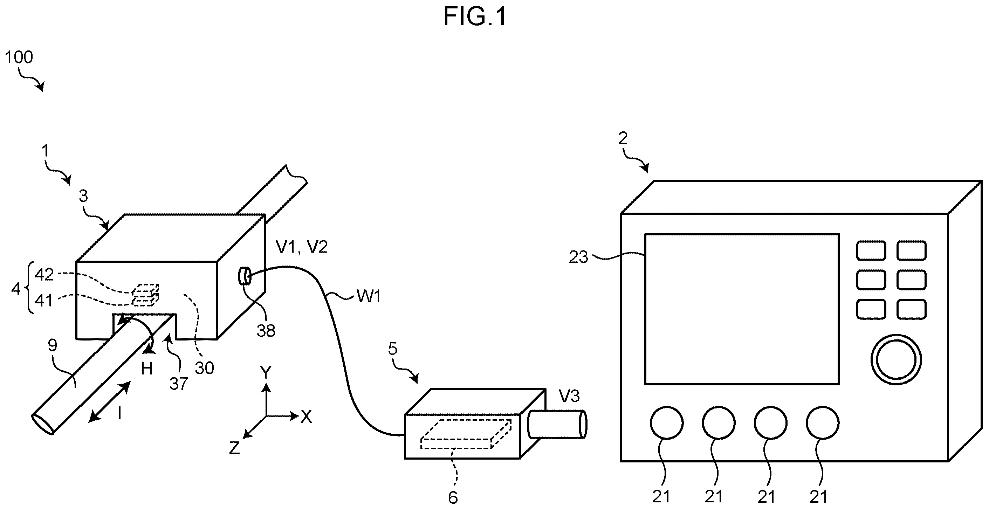

FIG. 1 is a diagram illustrating an example of a schematic configuration of an electric current measurement device 100 according to an embodiment. The electric current measurement device 100 includes an electric current sensor 1 and an external device 2.

The electric current sensor 1 detects an electric current that flows through a conductor 9. The electric current sensor 1 is used by being connected to the external device 2. In the example illustrated in FIG. 1, the external device 2 is an oscilloscope and displays, for example, a waveform of the electric current detected by the electric current sensor 1. Among components of the external device 2, FIG. 1 illustrates an input terminal 21 and a display unit 23 with reference signs assigned thereto.

The conductor 9 is provided in, for example, a hybrid vehicle (HV) or an electric vehicle (EV) and used to pass an electric current of several amperes to several tens of amperes or more. Examples of the conductor 9 include a cable and a busbar, which are for connecting a battery and a power unit to each other or connecting a converter and an inverter to each other.

The electric current flowing through the conductor 9 will be referred to and illustrated as an electric current I. An arrow in FIG. 1 schematically illustrates directions of the electric current I. The electric current I may be a direct electric current or an alternating electric current. The frequency of the electric current I (the fundamental frequency) will be referred to as a frequency f. A magnetic field is generated by the electric current I flowing through the conductor 9. This magnetic field will be referred to and illustrated as a magnetic field H. An arrow in FIG. 1 schematically illustrates directions of the magnetic field H.

An XYZ coordinate system is also illustrated in the drawings. A Z-axis direction corresponds to the direction, in which the conductor 9 extends. An X-axis direction and a Y-axis direction (an XY plane direction) correspond to the cross-sectional direction of the conductor 9. The positive X-axis direction and the negative X-axis direction will also be referred to as a left and right direction. The positive Y-axis direction and the negative Y-axis direction may also be referred to as an up and down direction. The positive Z-axis direction and the negative Z-axis direction may also be referred to as a forward and backward direction.

The electric current sensor 1 includes a shield 3, a magnetic field sensor 4, an external unit 5, and a detection circuit 6. In the example illustrated in FIG. 1, the shield 3 includes the magnetic field sensor 4, and the external unit 5 includes the detection circuit 6. The shield 3 corresponds to a head portion (a sensor head) of the electric current sensor 1 and is used by being placed near the conductor 9. The external unit 5 is connected to the input terminal 21 of the external device 2.

The shield 3 is configured to block magnetic fields. The shield 3 may be called a magnetic field shield. Any of various publicly known materials including metallic materials may be used for the shield 3.

The shield 3 has an opening 37. The opening 37 is used to capture (part of) the magnetic field H in the shield 3, the magnetic field H having been generated by the electric current flowing through the conductor 9. In this example, the opening 37 is formed by a lower portion of the shield 3 being cut out. The opening 37 may also be called a cutout.

The shield 3 is fitted to the conductor 9 so that the conductor 9 passes through the opening 37 of the shield 3, and the shield 3 is fixed so that the position of the conductor 9 is not changed. Methods for this fitting and fixing are not particularly limited. For example, near the opening 37 of the shield 3, a hook shaped member or a ring-shaped member for fitting the shield 3 (sensor head) to the conductor 9 may be used, and a spring member for fixing the shield 3 fitted may be used.

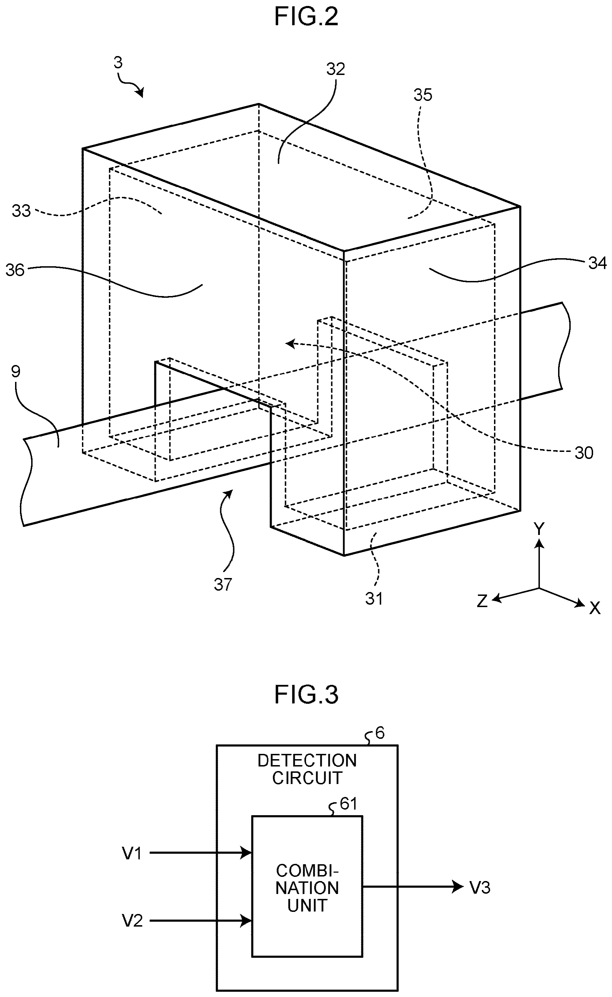

FIG. 2 is a diagram illustrating an example of a schematic configuration of the shield 3. The shield 3 is hollow and approximately box-shaped. The shield 3 includes a bottom plate 31, an upper plate 32, a side plate 33, a side plate 34, a side plate 35, and a side plate 36. The bottom plate 31, the upper plate 32, and the side plates 33 to 36 are magnetically connected closely or coupled to each other to define the shape of the shield 3 such that the shield 3 has an internal space 30 in the shield 3 and has the opening 37.

The bottom plate 31 and the upper plate 32 are positioned opposite to each other with the internal space 30 interposed between the bottom plate 31 and the upper plate 32 in the up and down direction (Y-axis direction) and extend to face each other with their planes being along an XZ plane. In the positive Y-axis direction, the bottom plate 31, the internal space 30, and the upper plate 32 are positioned in this order.

The side plate 33 and the side plate 34 are positioned opposite to each other with the internal space 30 interposed between the side plate 33 and the side plate 34 in the left and right direction (X-axis direction) and extend to face each other with their planes being along a YZ plane. In the positive X-axis direction, the side plate 33, the internal space 30, and the side plate 34 are positioned in this order.

The side plate 35 and the side plate 36 are positioned opposite to each other with the internal space 30 interposed between the side plate 35 and the side plate 36 in the forward and backward direction (Z-axis direction) and extend to face each other with their planes being along an XY plane. In the positive Z-axis direction, the side plate 35, the internal space 30, and the side plate 36 are positioned in this order.

In this example, the opening 37 is formed by portions of the bottom plate 31, the side plate 35, and the side plate 36 being cut out and extends over the entire shield 3 in the forward and backward direction (Z-axis direction). The area (the size) of the opening 37 along the XY plane is designed to allow the conductor 9 to pass through the opening 37.

Unless specifically described otherwise, "in the shield 3" means "in the internal space 30 of the shield 3". To the extent that there is no inconsistency, "in the shield 3" and "in the internal space 30" may be read interchangeably as appropriate.

As illustrated in FIG. 1, the magnetic field H, generated by the electric current I flowing through the conductor 9, in a portion positioned at the opening 37 of the shield 3, is captured in the shield 3 via the opening 37.

The magnetic field sensor 4 is placed at a position in the shield 3 and detects a magnetic field at that position. Any magnetic field (any magnetic field that may be a disturbance) other than the magnetic field H is blocked by the shield 3 and the magnetic field sensor 4 thus detects the magnetic field H at that position. Detection of the magnetic field H may include detection of an intensity of the magnetic field H or detection of a direction of the magnetic field H.

Specifically, the magnetic field sensor 4 outputs a sensor voltage corresponding to the magnetic field H at that position. In a state where the shield 3 has been fitted and fixed to the conductor 9, a relation between the electric current I (the intensity and direction) and the sensor voltage is uniquely determined. This relation is known beforehand on the basis of, for example, designs of the shield 3 and the magnetic field sensor 4, specifications of the conductor 9, and experimental data.

The magnetic field sensor 4 may be a plurality of magnetic field sensors. In the example illustrated FIG. 1, there are two magnetic field sensors. A first magnetic field sensor is referred to and illustrated as a magnetic field sensor 41. A second magnetic field sensor is referred to and illustrated as a magnetic field sensor 42. In a case where these magnetic field sensors are not distinguished from each other, they will simply be referred to as the magnetic field sensor 4.

The magnetic field sensor 41 and the magnetic field sensor 42 have detection characteristics different from each other. The magnetic field sensor 41 detects magnetic fields (low-frequency magnetic fields) having comparatively low frequencies. These low-frequency magnetic fields include direct current magnetic fields. The magnetic field sensor 42 detects magnetic fields (high-frequency magnetic fields) having comparatively high frequencies. Cutoff frequencies in frequency bands of these low-frequency magnetic fields and high-frequency magnetic fields need to overlap each other.

Various publicly known magnetic field sensors may be used. One example of the magnetic field sensor 41 is an integrated circuit (IC) sensor configured to include a Hall generator, and this IC sensor is also referred to as an analog Hall IC. One example of the magnetic field sensor 42 is a coil sensor configured to include a coil. A Rogowski coil may be used, and because Rogowski coils are able to be downsized, using a Rogowski coil facilitates placement of the magnetic field sensor 42 in the shield 3.

Unless particularly described otherwise, the magnetic field sensor 41 is configured to include an IC sensor. The magnetic field sensor 42 is configured to include a coil sensor. A sensor voltage output by the magnetic field sensor 41 will be referred to as a sensor voltage V1. A sensor voltage output by the magnetic field sensor 42 will be referred to as a sensor voltage V2. In a case where these sensor voltages are not distinguished from each other, they will simply be referred to as a sensor voltage.

The sensor voltage V1 from the magnetic field sensor 41 and the sensor voltage V2 from the magnetic field sensor 42 are led outside the shield 3 and supplied to the detection circuit 6 in the external unit 5. In the example illustrated in FIG. 1, the shield 3 has a terminal 38. In the shield 3, the magnetic field sensor 41 and the magnetic field sensor 42 are connected to the terminal 38 via, for example, wiring not illustrated in FIG. 1. Outside the shield 3, the terminal 38 is connected to the detection circuit 6 in the external unit 5 via wiring W1.

The detection circuit 6 is placed outside the shield 3 and detects the electric current I on the basis of the sensor voltage from the magnetic field sensor 4, that is, in this example, the sensor voltage V1 from the magnetic field sensor 41 and the sensor voltage V2 from the magnetic field sensor 42. This will be described by reference also to FIG. 3.

FIG. 3 is a diagram illustrating an example of the detection circuit 6. The detection circuit 6 combines the sensor voltage V1 and the sensor voltage V2 to generate a detection voltage V3. The detection voltage V3 is a voltage indicating a value of the electric current I and may more particularly be a voltage indicating an instantaneous value of the electric current I. This detection voltage V3 corresponds to a detection result from the detection circuit 6, that is, a detection result for the electric current I by the electric current sensor 1, and thus a measurement result for the electric current I by the electric current measurement device 100.

As described already, the relation between the electric current I flowing through the conductor 9 and the sensor voltage from the magnetic field sensor 4, that is, the sensor voltage V1 from the magnetic field sensor 41 and the sensor voltage V2 from the magnetic field sensor 42, is known beforehand. The detection circuit 6 has been designed to generate the detection voltage V3 from the sensor voltage V1 and the sensor voltage V2 on the basis of this relation.

Specifically, in the example illustrated in FIG. 3, the detection circuit 6 includes a combination unit 61. The combination unit 61 combines the sensor voltage V1 and the sensor voltage V2 so that the detection voltage V3 is acquired. One example of this combination is addition, and more specifically, this addition may be weighted addition. The combination unit 61 executes, for example, calculation expressed by Equation 1 below. In Equation 1, $\alpha$ is a weighting coefficient (which may also be called a gain) that the sensor voltage V1 is multiplied by. Furthermore, $\beta$ is a weighting coefficient that the sensor voltage V2 is multiplied by.

$$V3 = \alpha \times V1 + \beta \times V2 \qquad\qquad (1)$$

The external unit 5 illustrated in FIG. 1 outputs the detection voltage V3 generated by the detection circuit 6. The detection voltage V3 is output to the external device 2 placed outside the shield 3 and one example of the external device 2 is an oscilloscope. On the basis of the detection voltage V3 from the detection circuit 6, a waveform of the electric current I is displayed, and calculation results, such as the maximum value and minimum value and the frequency, are displayed.

The higher the frequency f of the electric current I, the higher the possibility of occurrence of the skin effect in the conductor 9. The skin effect in the conductor 9 may hereinafter be simply referred to as the skin effect.

The distribution of the magnetic field H in the shield 3 when the skin effect has occurred (when the skin effect is present) is different from that when the skin effect has not occurred (when the skin effect is not present). For some positions in the shield 3, even if the magnitude of the electric current I is the same, intensities of the magnetic field H at these positions differ from each other according to whether or not the skin effect is present.

The frequency characteristics in a high frequency region is changed due to the skin effect and the value of the sensor voltage V2 from the magnetic field sensor 42, which detects high-frequency magnetic fields, is changed in particular and the value of the detection voltage V3 is thus also changed. As a result, precision of measurement of the electric current I deteriorates. This problem is addressed by techniques disclosed herein. There are mainly two methods.

They will be described in order.

First Method

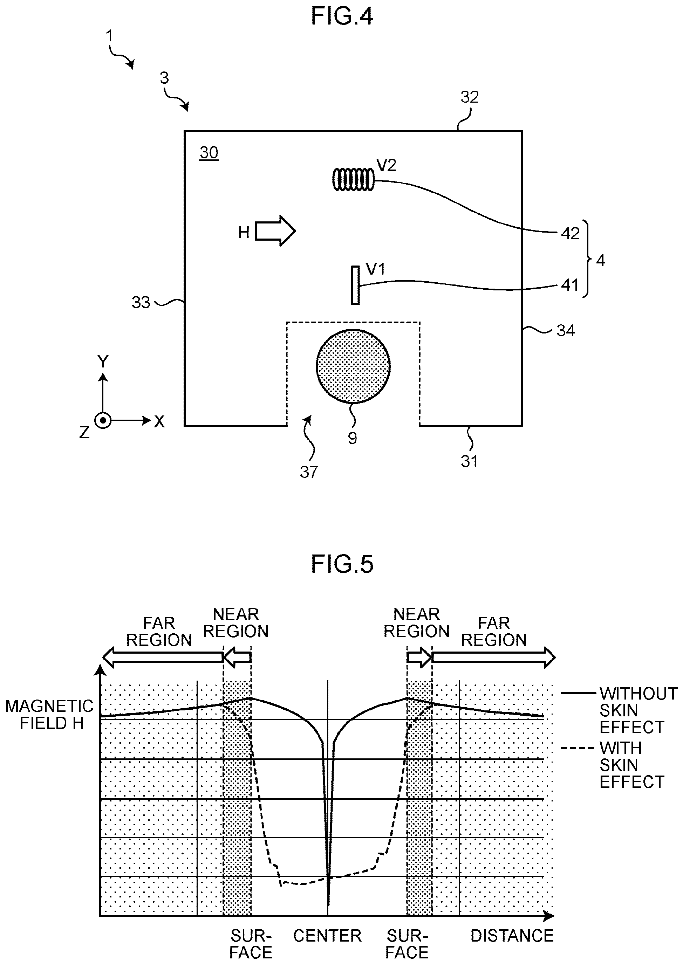

In a first method, placement of the magnetic field sensor 41 and the magnetic field sensor 42 in the shield 3 is improved. The first method will be described by reference to FIG. 4 to FIG. 17.

FIG. 4 is a diagram illustrating an example of a schematic configuration of the electric current sensor 1. Placement of the magnetic field sensor 4 in the shield 3, as viewed in the forward and backward direction (Z-axis direction), is schematically illustrated.

The magnetic field sensor 41 is placed near the opening 37 than the magnetic field sensor 42. The magnetic field sensor 42 is placed farther from the opening 37 than the magnetic field sensor 41. Since the conductor 9 passes through the opening 37, positions of the conductor 9 and the opening 37 may be regarded as substantially the same. In this context, the conductor 9 and the opening 37 may be read interchangeably as appropriate. That is, the magnetic field sensor 41 may be said to be placed near the conductor 9. The magnetic field sensor 42 may also be said to be placed far from the conductor 9.

More specifically, the magnetic field sensor 41 is placed in a near region near the conductor 9. This near region is a region where the magnetic field H changes in intensity according to whether or not the skin effect is present. The magnetic field sensor 42 is placed in a far region far from the conductor 9. This far region is a region where the magnetic field H is not changed in intensity according to whether or not the skin effect is present. The magnetic field H not changing in intensity herein may be interpreted to mean that minute magnetic field changes are included, the minute magnetic field changes hardly affecting the sensor voltage V2 from the magnetic field sensor 42 (being negligible). The near region and the far region will be described by reference also to FIG. 5.

FIG. 5 is a diagram illustrating an example of the near region and the far region. The horizontal axis in the graph represents distance from the center of the conductor 9. The vertical axis of the graph represents intensity of the magnetic field H. The intensity of the magnetic field H may be magnetic flux density and the intensity and the magnetic flux density may be read interchangeably as appropriate. The solid line in the graph represents the magnetic field H when no skin effect has occurred (without the skin effect). The broken line in the graph represents the magnetic field H when the skin effect has occurred (with the skin effect).

In a region near a surface of the conductor 9, the magnetic field H is changed according to whether or not the skin effect is present, as understood from FIG. 5. This region corresponds to the near region. In a region far, to a certain extent, from the surface of the conductor 9, the magnetic field H is not changed according to whether or not the skin effect is present. This region corresponds to the far region. In the example illustrated in FIG. 5, occurrence of the skin effect decreases the intensity of the magnetic field H in the near region.

As illustrated in FIG. 4, the magnetic field sensor 41 is placed at a position in the near region described above and outputs the sensor voltage V1 corresponding to the magnetic field H at that position. The magnetic field sensor 42 is placed at a position in the far region described above and outputs the sensor voltage V2 corresponding to the magnetic field H at that position.

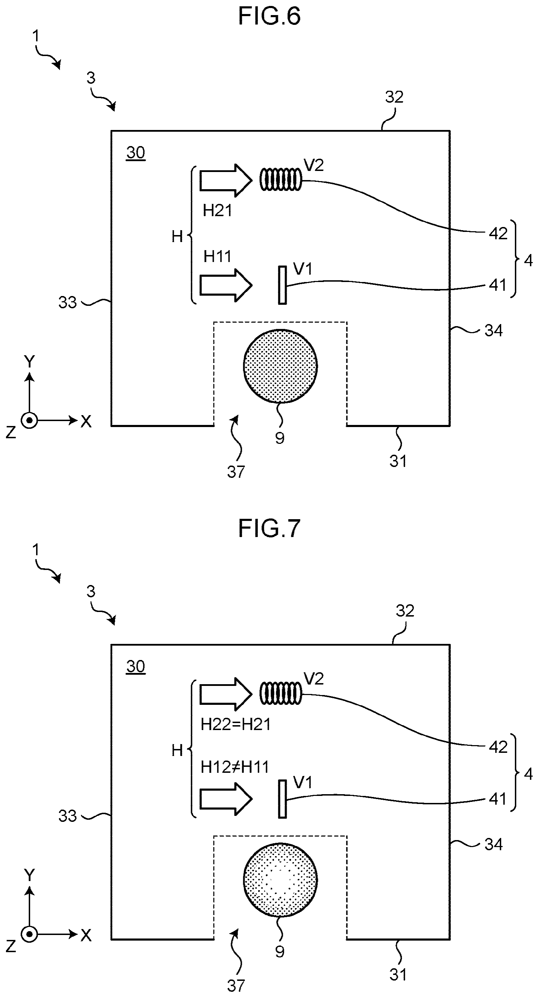

FIG. 6 and FIG. 7 are diagrams illustrating examples of operation. FIG. 6 illustrates the magnetic field H in the shield 3 when the skin effect has not occurred. The magnetic field H at the position (near region) of the magnetic field sensor 41 when the skin effect has not occurred will be referred to and illustrated as a magnetic field H11. The magnetic field H at the position (far region) of the magnetic field sensor 42 then will be referred to and illustrated as a magnetic field H21. FIG. 7 illustrates the magnetic field H in the shield 3 when the skin effect has occurred. The magnetic field H at the position of the magnetic field sensor 41 when the skin effect has occurred will be referred to and illustrated as a magnetic field H12. The magnetic field H at the position of the magnetic field sensor 42 then will be referred to and illustrated as a magnetic field H22.

At the position of the magnetic field sensor 41, the magnetic field H is changed according to whether or not the skin effect is present. Therefore, the magnetic field H12 is different from the magnetic field H11. At the position of the magnetic field sensor 42, the magnetic field H is not changed according to whether or not the skin effect is present. Therefore, the magnetic field H22 is the same as the magnetic field H21.

On the basis of the sensor voltage V1 and the sensor voltage V2 from the magnetic field sensor 41 and the magnetic field sensor 42 that have been placed as described above, the detection circuit 6 generates the detection voltage V3. The combination unit 61 of the detection circuit 6 combines the sensor voltage V1 and the sensor voltage V2 as expressed by Equation 1 described already, for example, so that the detection voltage V3 is acquired.

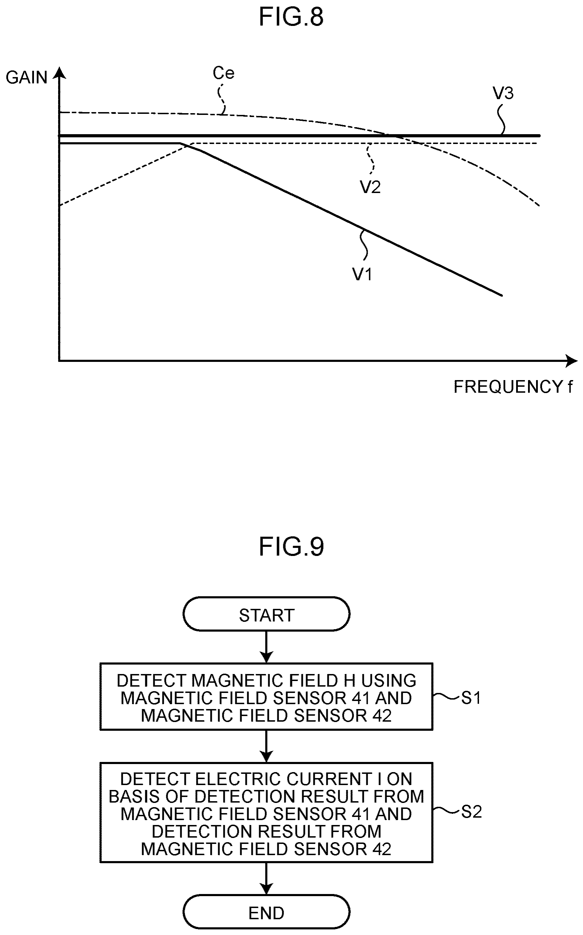

In one embodiment, the combination unit 61 of the detection circuit 6 may combine the sensor voltage V1 and the sensor voltage V2 so that frequency gain characteristics of the detection voltage V3 in relation to the electric current I become constant. This will be described by reference also to FIG. 8.

FIG. 8 is a diagram illustrating an example of frequency characteristics. The horizontal axis of the graph represents the frequency f of the electric current I. The vertical axis of the graph represents gain. The gain represents gain up to an output portion (corresponding to an output portion of the combination unit 61) of the detection circuit 6 in relation to the electric current I.

A line Ce in the graph represents a frequency characteristic of the skin effect. The skin effect divides the detection level for the magnetic field into a low frequency region where the gain is constant and a high frequency region where the gain decreases. A cutoff frequency is set between the low frequency region and the high frequency region.

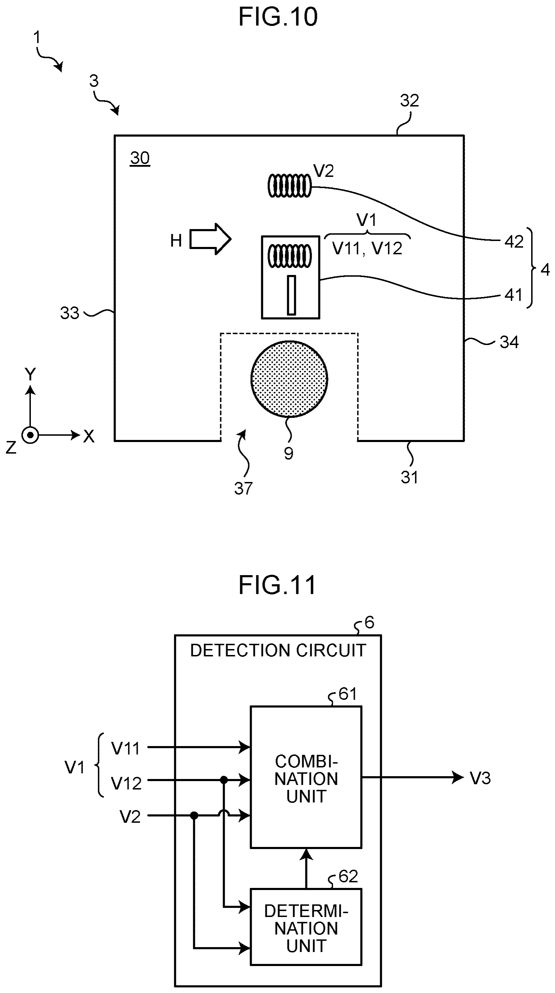

In the combination unit 61 (for example, in FIG. 3 described already and FIG. 11 described later), a first-order low-pass filter is applied to the sensor voltage V1 as the cutoff frequency. Similarly, a first-order high-pass filter is applied to the sensor voltage V2 as the cutoff frequency.

Furthermore, in the combination unit 61, the respective gains are adjusted so that detection voltages for the sensor voltage V1 and the sensor voltage V2 will be at the same level. Signals of the sensor voltage V1 and the sensor voltage V2 adjusted in level are combined by being added together and a result of the combination is output as the detection voltage V3. A frequency characteristic with a constant gain is thereby able to be acquired, as represented by a line V3 in the graph of FIG. 8.

Because a frequency region of the sensor voltage V1 of the magnetic field sensor 41 is blocked, the frequency region being higher than the cutoff frequency and susceptible to the skin effect, even if the magnetic field sensor 41 is placed near the opening 37, the sensor voltage V1 is not influenced by the skin effect. Being based on the sensor voltage V1 of the magnetic field sensor 41 placed near the conductor 9 enables precise detection of the magnetic field H and precise measurement of the electric current I.

The sensor voltage V2 of the magnetic field sensor 42 is placed far from the opening 37 of the magnetic field sensor 42 and is thus not influenced by the skin effect. By blocking a frequency region lower than the cutoff frequency and compensating the blocked frequency region with the sensor voltage V1 of the magnetic field sensor 41, a high frequency region is secured. Because the magnetic field sensor 42 is not affected by the skin effect at its position (far region), as compared to a case where the magnetic field sensor 42 is arranged in the near region, the magnetic field H is detected precisely and the electric current I is thus measured precisely.

By improving the placement of the magnetic field sensor 41 and the magnetic field sensor 42 in the shield 3 as described above, reduction in precision of measurement of the electric current I is able to be minimized, the reduction being due to the skin effect.

FIG. 9 is a flowchart illustrating an example of a process (an electric current measurement method) executed at the electric current sensor 1. Any redundant description of what has been described already will be omitted as appropriate.

At Step S1, the magnetic field H is detected by use of the magnetic field sensor 41 and the magnetic field sensor 42. The magnetic field sensor 41 outputs the sensor voltage V1 corresponding to the magnetic field H at the position of the magnetic field sensor 41 in the shield 3. The magnetic field sensor 42 outputs the sensor voltage V2 corresponding to the magnetic field H at the position of the magnetic field sensor 42 in the shield 3.

At Step S2, on the basis of a detection result from the magnetic field sensor 41 and a detection result from the magnetic field sensor 42, the electric current I is detected. The detection circuit 6 arranged outside the shield 3 generates, on the basis of the sensor voltage V1 from the magnetic field sensor 41 and the sensor voltage V2 from the magnetic field sensor 42, the detection voltage V3 indicating the electric current I.

Determination on Whether or not Skin Effect is Present

A technique enabling a determination on whether or not the skin effect in the conductor 9 has occurred (whether or not the skin effect is present) would be useful. An example of a determination method will be described by reference to FIG. 10 to FIG. 14.

FIG. 10 is a diagram illustrating an example of a schematic configuration of the electric current sensor 1. In this example, the magnetic field sensor 41 is configured to include, not only the IC sensor, but also a coil sensor, to enable detection of not only low frequency magnetic fields but also high frequency magnetic fields. The sensor voltage V1 of the magnetic field sensor 41 includes a sensor voltage V11 output by the IC sensor and a sensor voltage V12 output by the coil sensor. The magnetic field sensor 42 is configured to include a coil sensor as described above and outputs the sensor voltage V2.

FIG. 11 is a diagram illustrating an example of a schematic configuration of the detection circuit 6. The detection circuit 6 further includes a determination unit 62, in addition to the combination unit 61.

The determination unit 62 determines whether or not the skin effect has occurred, on the basis of the sensor voltage V1 from the magnetic field sensor 41 and the sensor voltage V2 from the magnetic field sensor 42. More specifically, on the basis of a ratio between the sensor voltage V12 from the coil sensor included in the magnetic field sensor 41 and the sensor voltage V2 from the coil sensor included in the magnetic field sensor 42, the determination unit 62 determines whether or not the skin effect is present. This ratio will be referred to as a ratio R. For example, the ratio R is a ratio of the sensor voltage V2 to the sensor voltage V12 (that is, $R = V2/V12$).

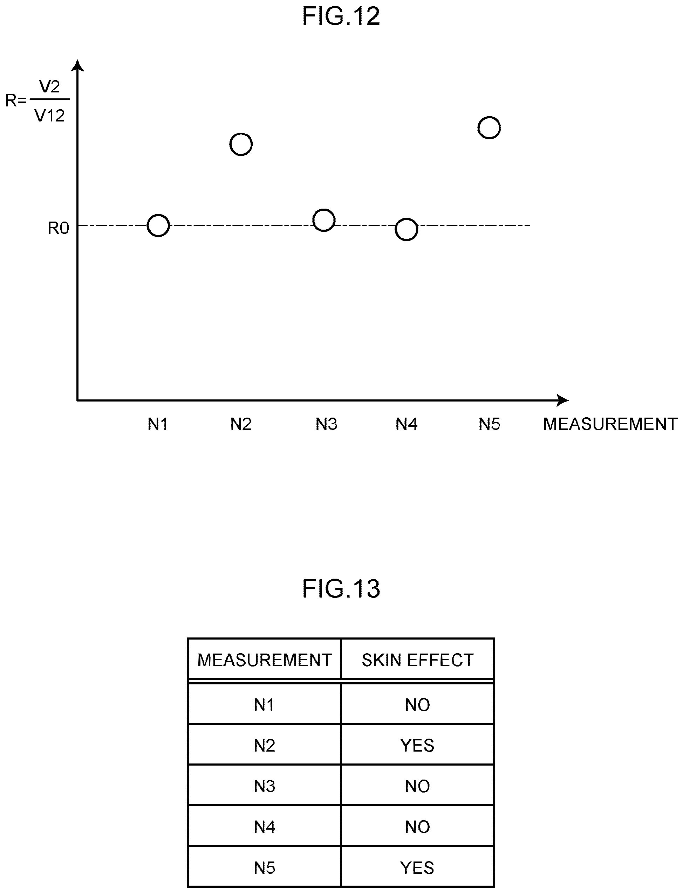

FIG. 12 and FIG. 13 are diagrams illustrating an example of determinations on whether or not the skin effect is present. The horizontal axis in the graph of FIG. 12 represents measurements under different conditions. Examples of these conditions include the type of the conductor 9, and the frequency f of the electric current I. In this example, five kinds of measurements under different conditions are illustrated as a measurement N1 to a measurement N5. The vertical axis of the graph represents the ratio R. Plots in the graph represent the ratios R in the respective measurements.

Values of the ratio R are broadly classified into two values according to whether or not the skin effect is present. This is because in contrast to the sensor voltage V12 from the magnetic field sensor 41 being changed according to whether or not the skin effect is present, the sensor voltage V2 from the magnetic field sensor 42 is not changed. The value of the ratio R when the skin effect has not occurred will be referred to as a reference value R0.

When the skin effect has occurred, intensity of the magnetic field H in the near region is changed and the sensor voltage V12 from the magnetic field sensor 41 is thus also changed. The ratio R deviates from the reference value R0. For example, in a case where the intensity of the magnetic field H is decreased in the near region as illustrated in FIG. 5 described already, the ratio R increases and deviates from the reference value R0.

In a case where the ratio R is close to the reference value R0 (including agreement), the detection circuit 6 determines that the skin effect has not occurred. Otherwise, that is, in a case where the ratio R has deviated from the reference value R0, the detection circuit 6 determines that the skin effect has occurred. In determining whether or not the ratio R is close to the reference value R0, for example, threshold determination for the absolute value (|R - R0|) of the difference between the ratio R and the reference value R0 may be used.

As illustrated in FIG. 13, in the measurement N1, the measurement N3, and the measurement N4, because the ratio R is close to the reference value R0, it is determined that the skin effect has not occurred. On the contrary, in the measurement N2 and the measurement N5, because the ratio R is deviated from the reference value R0, it is determined that the skin effect has occurred.

An example of application of a determination result from the determination unit 62 will now be described by reference to FIG. 11. In one embodiment, according to a determination result from the determination unit 62, the detection circuit 6 may alternatively use the sensor voltage V1 from the magnetic field sensor 41 and the sensor voltage V2 from the magnetic field sensor 42.

Specifically, when the skin effect has not occurred, the combination unit 61 generates the detection voltage V3 on the basis of the sensor voltage V1 from the magnetic field sensor 41. The sensor voltage V2 from the magnetic field sensor 42 may be not used. Being based on the sensor voltage V1 from the magnetic field sensor 41 placed near the conductor 9 enables precise detection of the magnetic field H and therefore precise measurement of the electric current I.

In contrast, when the skin effect has occurred, the combination unit 61 generates the detection voltage V3 on the basis of the sensor voltage V2 from the magnetic field sensor 42. The sensor voltage V1 of the magnetic field sensor 41 may be not used. Because the magnetic field sensor 42 is not affected by the skin effect, the magnetic field H is detected precisely and the electric current I is therefore measured precisely.

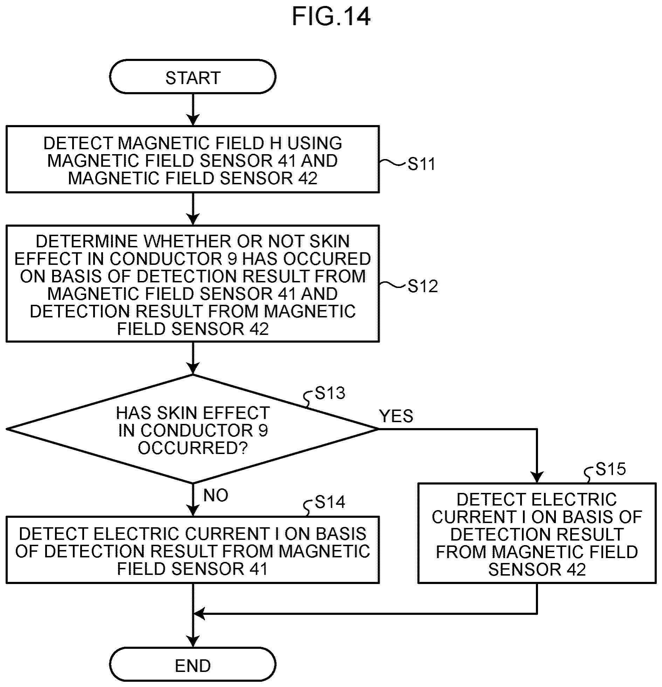

FIG. 14 is a flowchart illustrating an example of a process (an electric current measurement method) executed at the electric current sensor 1. Any redundant description of what has been described already will be omitted as appropriate.

At Step S11, the magnetic field H is detected by use of the magnetic field sensor 41 and the magnetic field sensor 42. The magnetic field sensor 41 outputs the sensor voltage V1, more specifically, the sensor voltage V11 and the sensor voltage V12. The magnetic field sensor 42 outputs the sensor voltage V2.

At Step S12, on the basis of a detection result from the magnetic field sensor 41 and a detection result from the magnetic field sensor 42, whether or not the skin effect in the conductor 9 has occurred is determined. On the basis of the ratio R between the sensor voltage V12 and the sensor voltage V2, the determination unit 62 of the detection circuit 6 determines whether or not the skin effect is present.

At Step S13, the process branches according to a result of the determination at Step S12. In a case where the skin effect in the conductor 9 has occurred (Step S13: Yes), the process is advanced to Step S15. In a case where the skin effect in the conductor 9 has not occurred (Step S13: No), the process is advanced to Step S14.

At Step S14, on the basis of a detection result from the magnetic field sensor 41, the electric current I is detected. The determination unit 62 of the detection circuit 6 generates the detection voltage V3 on the basis of the sensor voltage V1 from the magnetic field sensor 41 (for example, only the sensor voltage V11 from the IC sensor).

At Step S15, on the basis of the detection result from the magnetic field sensor 42, the electric current I is detected. The determination unit 62 of the detection circuit 6 generates the detection voltage V3 on the basis of the sensor voltage V2 from the magnetic field sensor 42.

Movement of Sensor

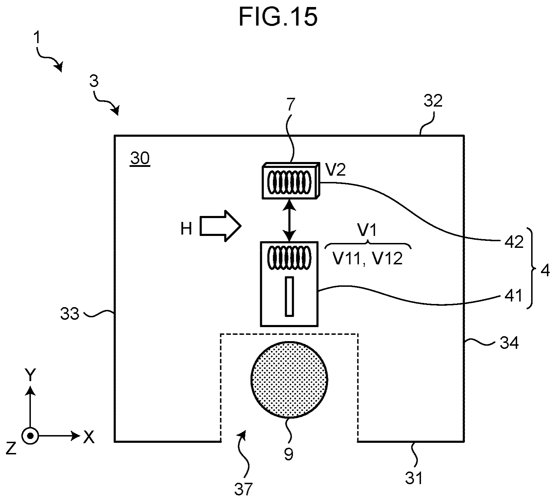

In one embodiment, the magnetic field sensor 42 may be dynamically placed near or far from the opening 37 in the shield 3. This will be described by reference to FIG. 15.

FIG. 15 is a diagram illustrating an example of a schematic configuration of the electric current sensor 1. The magnetic field sensor 41 is placed near the opening 37. The magnetic field sensor 42 is movable in the shield 3 and is capable of being placed near the opening 37 and being placed far from the opening 37.

The electric current sensor 1 includes a movement mechanism 7 that moves the magnetic field sensor 4, more specifically, the magnetic field sensor 42. The movement mechanism 7 moves the magnetic field sensor 42 between a position near the opening 37 and a position far from the opening 37. A specific configuration of the movement mechanism 7 is not particularly limited, and any configuration enabling the magnetic field sensor 42 to be physically moved may be adopted. For example, the movement mechanism 7 may be configured to include a support unit that supports the magnetic field sensor 42, and a drive unit (for example, an actuator) for moving the support unit.

The movement mechanism 7 moves the magnetic field sensor 42 such that the magnetic field sensor 42 is placed near the opening 37 when the skin effect has not occurred and the magnetic field sensor 42 is arranged far from the opening 37 when the skin effect has occurred. Determination on whether or not the skin effect is present is performed at the detection circuit 6 as described already.

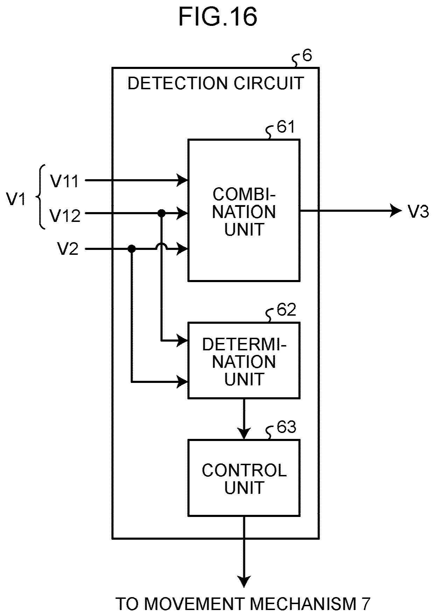

The movement of the magnetic field sensor 42 by the movement mechanism 7 may be controlled by the detection circuit 6. This will be described by reference also to FIG. 16.

FIG. 16 is a diagram illustrating an example of a schematic configuration of the detection circuit 6. The detection circuit 6 further includes a control unit 63. The control unit 63 controls the movement mechanism 7. For example, the control unit 63 generates a control signal and transmits the control signal to the movement mechanism, and the movement mechanism 7 moves the magnetic field sensor 42 according to the control signal.

A determination result from the determination unit 62 may be used also in the control of the movement mechanism 7 by the control unit 63. The control unit 63 in this case controls the movement mechanism 7 on the basis of the determination result from the determination unit 62. Specifically, the control unit 63 controls the movement mechanism 7 such that the magnetic field sensor 42 is placed near the opening 37 when the skin effect has not occurred and the magnetic field sensor 42 is placed far from the opening 37 when the skin effect has occurred.

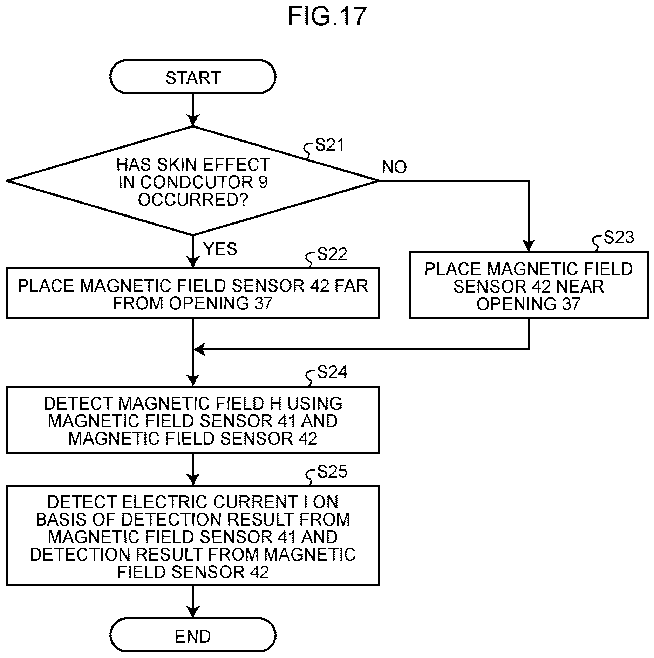

FIG. 17 is a flowchart illustrating an example of a process (an electric current measurement method) executed at the electric current sensor 1. Any redundant description of what has been described already will be omitted as appropriate.

At Step S21, whether or not the skin effect in the conductor 9 has occurred is determined. This determination is performed by the determination unit 62 of the detection circuit 6. In a case where the skin effect has occurred (Step S21: Yes), the process is advanced to Step S22. In a case where the skin effect has not occurred (Step S21: No), the process is advanced to Step S23.

At Step S22, the magnetic field sensor 42 is placed far from the opening 37. The control unit 63 of the detection circuit 6 generates a control signal for this placement and transmits the control signal to the movement mechanism 7. The movement mechanism 7 moves the magnetic field sensor 42 so that the magnetic field sensor 42 is placed far from the opening 37. In a case where the magnetic field sensor 42 has already been placed far from the opening 37, this processing at Step S22 may be skipped.

At Step S23, the magnetic field sensor 42 is placed near the opening 37. The control unit 63 generates a control signal for this placement and transmits the control signal to the movement mechanism 7. The movement mechanism 7 moves the magnetic field sensor 42 so that the magnetic field sensor 42 is placed near the opening 37. In a case where the magnetic field sensor 42 has already been placed near the opening 37, this processing at Step S23 may be skipped.

After the processing at Step 22 or Step S23 is completed, the process is advanced to Step S24 and then to Step S25 in this order. Processing at these Steps S24 and S25 may be the same as the processing at Step S1 and Step S2 in FIG. 9 described already. That is, the magnetic field H is detected by use of the magnetic field sensor 41 and the magnetic field sensor 42, and the electric current I is detected on the basis of a detection result from the magnetic field sensor 41 and a detection result from the magnetic field sensor 42.

As described above, in this first method, improving the placement of the magnetic field sensor 41 and the magnetic field sensor 42 in the shield 3 enables minimization of reduction in precision of measurement of the electric current I, the reduction being due to the skin effect.

Second Method

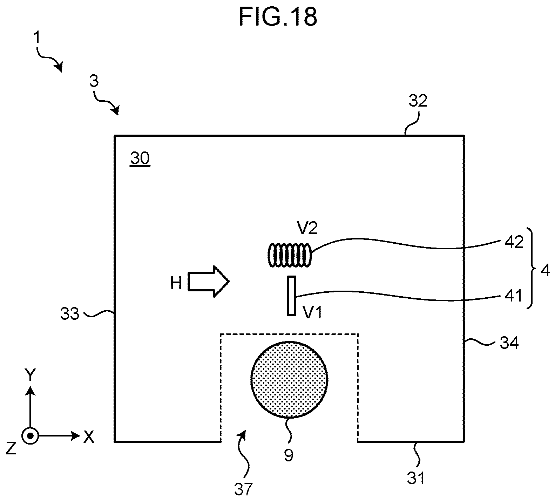

In a second method, the detection voltage V3 output by the detection circuit 6 is corrected. This will be described by reference also to FIG. 18 to FIG. 24.

FIG. 18 is a diagram illustrating an example of a schematic configuration of the electric current sensor 1. The magnetic field sensor 41 to detect low-frequency magnetic fields and the magnetic field sensor 42 to detect high-frequency magnetic fields are both placed near the opening 37. The sensor voltage V2 from the magnetic field sensor 42 is affected by the skin effect.

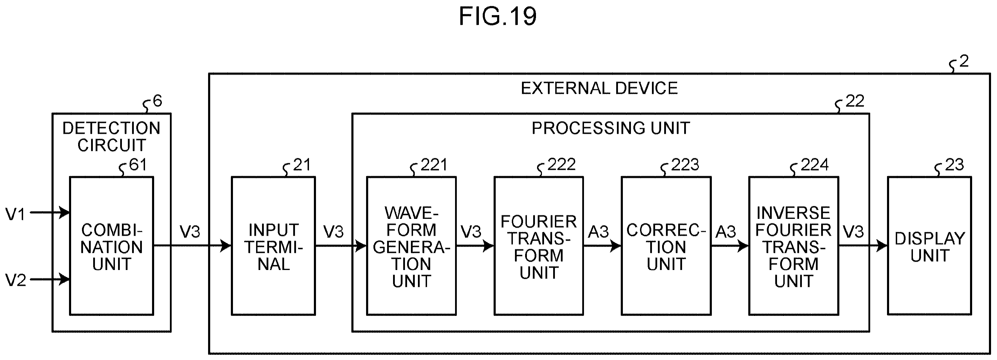

FIG. 19 is a diagram illustrating an example of a schematic configuration of the detection circuit 6 and the external device 2. The detection circuit 6 includes the combination unit 61 and generates the detection voltage V3 on the basis of the sensor voltage V1 and the sensor voltage V2. Because the sensor voltage V2 undergoes a change according to whether or not the skin effect is present, the detection voltage V3 also undergoes a change. To eliminate this change in the detection voltage V3, the detection voltage V3 is corrected by the external device 2.

The external device 2 corrects the detection voltage V3. The external device 2 includes a processing unit 22, in addition to the input terminal 21 and display unit 23 mentioned already.

The detection voltage V3 from the detection circuit 6 is input to the input terminal 21. The detection voltage V3 represents the value, more specifically, the instantaneous value, of the electric current I, as mentioned already. The detection voltage V3 corresponding to the instantaneous value of the electric current I that changes from moment to moment is input to the input terminal 21.

The processing unit 22 is configured to correct the detection voltage V3 to eliminate the influence of the skin effect from the detection voltage V3, that is, the change in the detection voltage V3, the change being due to the change in the sensor voltage V2. For example, at the processing unit 22, the detection voltage V3 is converted to data on a digital value and various kinds of data processing is executed on the data. A storage unit for storing various data needed for this processing may be included in the external device 2.

The processing unit 22 may be configured to include, for example, a general-purpose or dedicated processor and a memory. Functions of the processing unit 22 may be implemented by hardware design, software design, or both hardware design and software design. A program for causing the processing unit 22 to execute various processes is one of techniques disclosed herein.

Specifically, the processing unit 22 corrects the detection voltage V3 in the frequency domain. In the example illustrated in FIG. 19, the processing unit 22 includes a waveform generation unit 221, a Fourier transform unit 222, a correction unit 223, and an inverse Fourier transform unit 224.

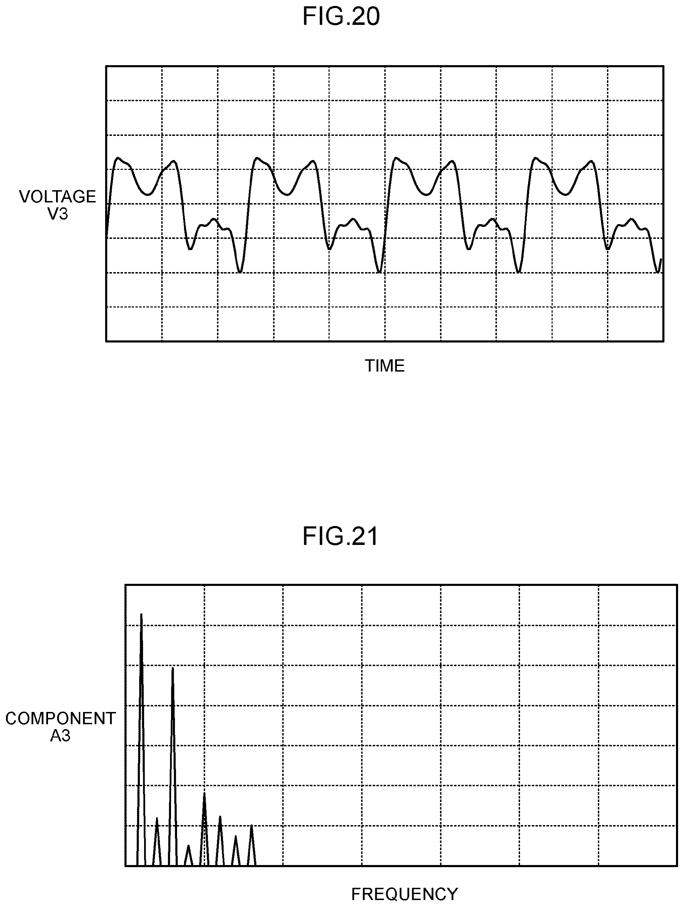

The waveform generation unit 221 is configured to generate a waveform of the detection voltage V3. This waveform of the detection voltage V3 is a waveform that has not been corrected by the processing unit 22 yet. On example will be described by reference to FIG. 20.

FIG. 20 is a diagram illustrating an example of a waveform of the detection voltage V3 that has not been corrected yet. The horizontal axis in the graph represents time. The vertical axis in the graph represents the detection voltage V3. This waveform of the detection voltage V3 is affected by the skin effect (for example, the waveform is deteriorated) and thus does not accurately represent the waveform of the electric current I.

The Fourier transform unit 222 illustrated in FIG. 19 is configured to perform Fourier transform of the waveform of the detection voltage V3 generated by the waveform generation unit 221. A frequency component of the detection voltage V3 is thereby acquired. The frequency component may include an amplitude value for each frequency and may also include a phase for each frequency. The frequency component of this detection voltage V3 is a frequency component that has not been corrected by the processing unit 22 yet. One example will be described by reference to FIG. 21.

FIG. 21 is a diagram illustrating an example of the frequency component of the detection voltage V3, the frequency component not having been corrected yet. The horizontal axis in the graph represents frequency. The vertical axis represents a component A3. This component A3 may be interpreted as including an amplitude component and a phase component. This frequency component of the detection voltage V3 is affected by the skin effect and thus does not accurately represent the frequency component of the electric current I.

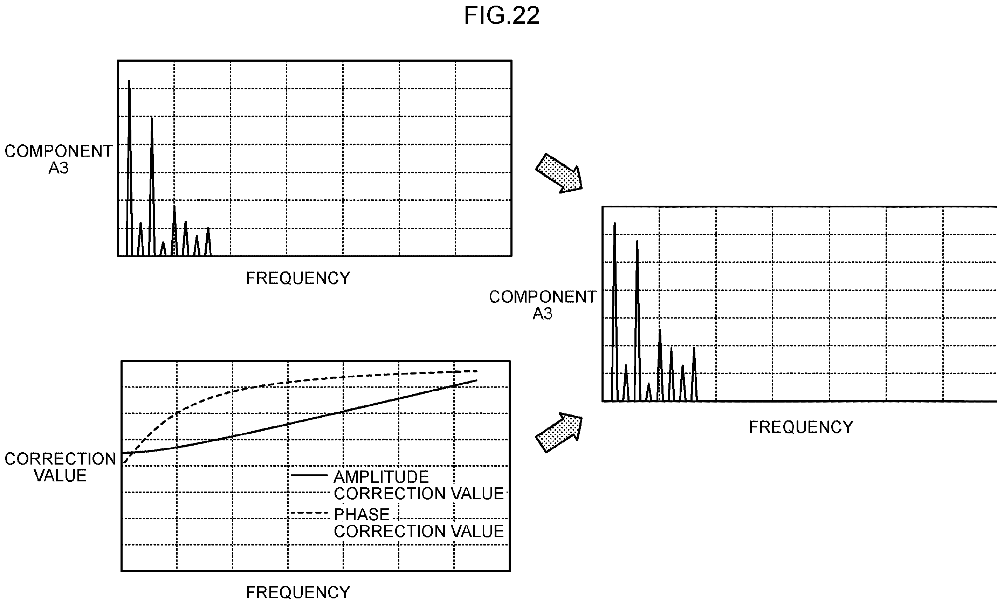

The correction unit 223 illustrated in FIG. 19 is configured to correct the frequency component of the detection voltage V3 acquired by Fourier transform at the Fourier transform unit 222. Specifically, the correction unit 223 corrects the frequency component of the detection voltage V3 by adding a correction value to the frequency component of the detection voltage V3 and multiplying the frequency component of the detection voltage V3 by a correction value. The correction values may include an amplitude correction value for correcting the amplitude and a phase correction value for correcting the phase. For example, the amplitude component of the detection voltage V3 is multiplied by the amplitude correction value, and the phase correction value is added to the phase component of the detection voltage V3. One example will be described by reference to FIG. 22.

FIG. 22 is a diagram illustrating an example of correction of the frequency component of the detection voltage V3. The graph at the top left in FIG. 22 represents the frequency component of the detection voltage V3, the frequency component not having been corrected yet, and this is the same as the graph in FIG. 21 described already.

The graph at the bottom left in FIG. 22 represents the correction values (amplitude correction value and phase correction value). The correction values are determined on the basis of frequency characteristics of the detection voltage V3 due to the skin effect. For example, the amount of change in the detection voltage V3 (the amounts of changes in amplitude and phase) in the frequency domain is measured beforehand for a case where the skin effect has occurred. Correction values to cancel these amounts of changes are calculated and stored in a storage unit in the external device 2 so as to be able to be used at the correction unit 223. By use of these correction values, the frequency component of the detection voltage V3 is corrected. The graph on the right in FIG. 22 represents the frequency component of the detection voltage V3, the frequency component having been corrected. Because the influence of the skin effect has been eliminated, this frequency component of the detection voltage V3 represents the frequency component of the electric current I accurately.

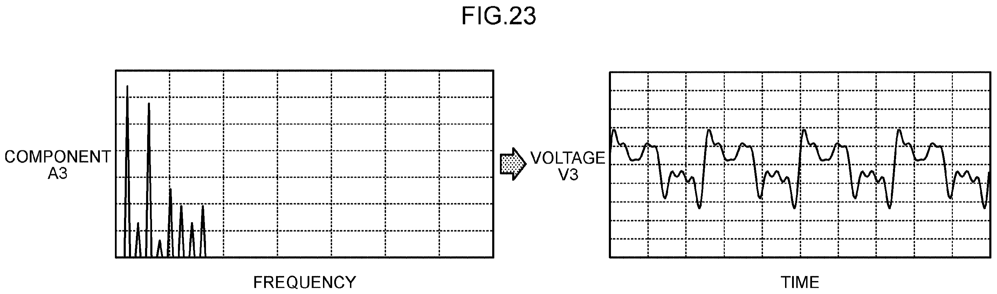

The inverse Fourier transform unit 224 illustrated in FIG. 19 is configured to perform inverse Fourier transform of the frequency component of the detection voltage V3, the frequency component having been corrected by the correction unit 223. A waveform of the detection voltage V3 is thereby acquired. The influence of the skin effect has been eliminated from this waveform of the detection voltage V3 and the waveform thus represents the waveform of the electric current I accurately. One example will be described by reference to FIG. 23.

FIG. 23 is a diagram illustrating an example of inverse Fourier transform. The graph on the left in FIG. 23 represents the frequency component of the detection voltage V3, the frequency component having been corrected, and this is the same as the graph on the right in FIG. 22 described already. The graph on the right in FIG. 23 represents the waveform of the detection voltage V3 acquired by the inverse Fourier transform. This waveform of the detection voltage V3 is the waveform of the detection voltage V3 that has been corrected and is different from the waveform of the detection voltage V3 that has not been corrected and illustrated in FIG. 20 described already (for example, the deterioration in the waveform has been eliminated).

The display unit 23 illustrated in FIG. 19 displays, as the waveform of the electric current I, the waveform of the detection voltage V3 that has been corrected by the processing unit 22. An accurate measurement result for the electric current I, from which the influence of the skin effect has been eliminated, is thereby displayed.

Correcting the detection voltage V3 at the external device 2 as described above also enables minimization of reduction in precision of measurement of the electric current I, the reduction being due to the skin effect.

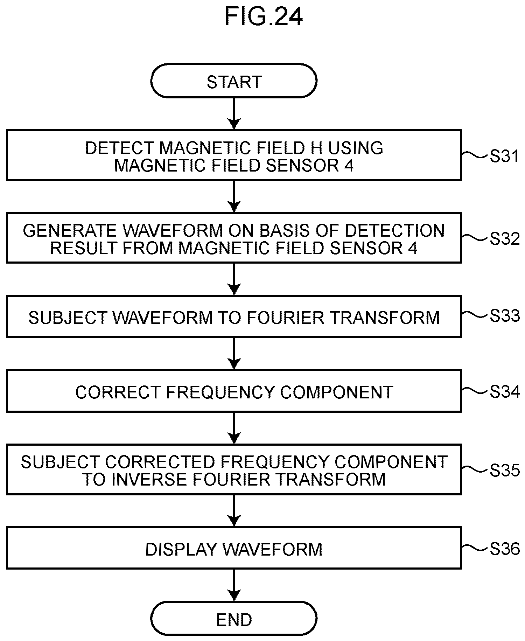

FIG. 24 is a flowchart illustrating an example of a process (an electric current measurement method) executed at the electric current measurement device 100. Any redundant description of what has been described already will be omitted as appropriate.

At Step S31, the magnetic field H is detected by use of the magnetic field sensor 4. The magnetic field sensor 41 and the magnetic field sensor 42 that have been placed at positions near the opening 37 output the sensor voltage V1 and the sensor voltage V2 corresponding to the magnetic field H at those positions.

At Step S32, on the basis of a detection result from the magnetic field sensor 4, a waveform is generated. On the basis of the sensor voltage V1 and the sensor voltage V2, the detection circuit 6 generates the detection voltage V3. The waveform generation unit 221 of the processing unit 22 in the external device 2 generates a waveform of the detection voltage V3.

At Step S33, the waveform is subjected to Fourier transform. The Fourier transform unit 222 of the processing unit 22 in the external device 2 performs Fourier transform of the waveform of the detection voltage V3. A frequency component of the detection voltage V3 is thereby acquired.

At Step S34, the frequency component is corrected. The correction unit 223 of the processing unit 22 in the external device 2 corrects the frequency component of the detection voltage V3 by using a correction value.

At Step S35, the frequency component that has been corrected is subjected to inverse Fourier transform. The inverse Fourier transform unit 224 of the processing unit 22 in the external device 2 performs inverse Fourier transform of the corrected frequency component of the detection voltage V3. A waveform of the corrected detection voltage V3 is thereby acquired.

At Step S36, the waveform is displayed. The display unit 23 in the external device 2 displays the waveform of the corrected detection voltage V3.

As described above, correcting the detection voltage V3 output by the detection circuit 6 in this second method enables minimization of reduction in precision of measurement of the electric current I, the reduction being due to the skin effect.

Overview

The above described techniques are defined as follows, for example. One of the technique disclosed herein is the electric current sensor 1. As described above by reference to FIG. 1 to FIG. 17, the electric current sensor 1 includes: the shield 3 having the opening 37 for capturing the magnetic field H in the shield 3, the magnetic field H having been generated by the electric current I flowing through the conductor 9; the magnetic field sensor 4 that is placed at a position in the shield 3 and outputs a sensor voltage corresponding to the magnetic field H at that position; and the detection circuit 6 that is placed outside the shield 3 and detects the electric current I on the basis of the sensor voltage from the magnetic field sensor 4. The magnetic field sensor 4 includes the magnetic field sensor 41 (first magnetic field sensor) to detect low-frequency magnetic fields and the magnetic field sensor 42 (second magnetic field sensor) to detect high-frequency magnetic fields. The magnetic field sensor 41 is placed nearer to the opening 37 than the magnetic field sensor 42 and the magnetic field sensor 42 is placed farther from the opening 37 than the magnetic field sensor 41. More specifically, the magnetic field sensor 41 is placed in a near region near the conductor 9, the magnetic field sensor 42 is placed in a far region far from the conductor 9, the near region may be a region where the magnetic field H is changed in intensity according to whether or not the skin effect in the conductor 9 is present, and the far region may be a region where the magnetic field H is not changed in intensity according to whether or not the skin effect in the conductor 9 is present.

As to the electric current sensor 1, the magnetic field sensor 42 to detect high-frequency magnetic fields is placed farther from the opening 37 than the magnetic field sensor 41 to detect low-frequency magnetic fields. The magnetic field sensor 42 is not affected by the skin effect in the conductor 9. When the frequency f of the electric current I is high and the skin effect has occurred, the sensor voltage V2 from the magnetic field sensor 42 to detect high-frequency magnetic fields dominates in the sensor voltage from the magnetic field sensor 4. On the basis of this sensor voltage, the electric current I is detected. Therefore, reduction in precision of measurement of the electric current I is able to be minimized, the reduction being due to the skin effect.

As described above by reference to FIG. 10 to FIG. 14, the detection circuit 6 may determine, on the basis of the sensor voltage from the magnetic field sensor 4, whether or not the skin effect in the conductor 9 has occurred; when the skin effect in the conductor 9 has not occurred, the detection circuit 6 may detect the electric current I on the basis of the sensor voltage V1 from the magnetic field sensor 41; and when the skin effect in the conductor 9 has occurred, the detection circuit 6 may detect the electric current I on the basis of the sensor voltage V2 from the magnetic field sensor 42. The electric current I is thereby able to be measured by alternative use of the sensor voltage V1 from the magnetic field sensor 41 and the sensor voltage V2 from the magnetic field sensor 42, according to whether or not the skin effect is present.

As described above by reference to FIG. 10 to FIG. 14, the magnetic field sensor 41 may further detect high-frequency magnetic fields, each of the magnetic field sensor 41 and the magnetic field sensor 42 may include a coil sensor to detect high-frequency magnetic fields, and the detection circuit 6 may determine, on the basis of the sensor voltage V12 from the coil sensor of the magnetic field sensor 41 and the sensor voltage V2 from the coil sensor of the magnetic field sensor 42 (for example, on the basis of the ratio R therebetween), whether or not the skin effect in the conductor 9 has occurred. Whether or not the skin effect in the conductor 9 is present is thereby able to be determined, for example.

The electric current sensor 1 described above by reference to FIG. 1 to FIG. 3 and FIG. 15 to FIG. 17 is another one of the techniques disclosed herein. The electric current sensor 1 includes: the shield 3 having the opening 37 for capturing the magnetic field H in the shield 3, the magnetic field H having been generated by the electric current I flowing through the conductor 9; the magnetic field sensor 4 that is placed at a position in the shield 3 and outputs a sensor voltage corresponding to the magnetic field H at that position; the detection circuit 6 that is placed outside the shield 3 and detects the electric current I on the basis of the sensor voltage from the magnetic field sensor 4; and the movement mechanism 7 that moves the magnetic field sensor 4. The magnetic field sensor 4 includes: the magnetic field sensor 41 (first magnetic field sensor) that is placed near the opening 37 and is to detect low-frequency magnetic fields; and the magnetic field sensor 42 (second magnetic field sensor) to detect high-frequency magnetic fields. The movement mechanism 7 moves the magnetic field sensor 42 between a position near the opening 37 and a position far from the opening 37. The detection circuit 6 in this case may determine, on the basis of the sensor voltage from the magnetic field sensor 4, whether or not the skin effect in the conductor 9 has occurred, and the movement mechanism 7 may move the magnetic field sensor 42 so that when the skin effect in the conductor 9 has not occurred, the magnetic field sensor 42 is placed near the opening 37 and when the skin effect in the conductor 9 has occurred, the magnetic field sensor 42 is placed far from the opening 37. The magnetic field sensor 42 is able to be placed far from the opening 37 by such a configuration enabling the magnetic field sensor 42 to be moved, and reduction in precision of measurement of the electric current I is thus able to be minimized as described already, the reduction being due to the skin effect.

The electric current measurement device 100 described above by reference to FIG. 1 to FIG. 3 and FIG. 18 to FIG. 24 is yet another one of the techniques disclosed herein. The electric current measurement device 100 includes: the shield 3 having the opening 37 for capturing the magnetic field H in the shield 3, the magnetic field H having been generated by the electric current I flowing through the conductor 9; the magnetic field sensor 4 that is placed at a position in the shield 3 and outputs a sensor voltage corresponding to the magnetic field H at that position; the detection circuit 6 that is placed outside the shield 3 and generates, on the basis of the sensor voltage from the magnetic field sensor 4, the detection voltage V3 indicating a value of the electric current I; and the external device 2 that is placed outside the shield 3 and corrects the detection voltage V3 in the frequency domain. More specifically, the sensor voltage (for example, the sensor voltage V2 from the magnetic field sensor 42) may undergo a change due to the skin effect in the conductor 9, the detection voltage V3 may undergo a change due to this change in the sensor voltage, and the external device 2 may correct the detection voltage V3 so as to eliminate the change in the detection voltage V3. The external device 2 may include: the waveform generation unit 221 that generates a waveform of the detection voltage V3; the Fourier transform unit 222 that performs Fourier transform of the waveform of the detection voltage V3; the correction unit 223 that corrects a frequency component of the detection voltage V3, the frequency component having been acquired by the Fourier transform; and the inverse Fourier transform unit 224 that performs inverse Fourier transform of the corrected frequency component of the detection voltage V3. Correcting the detection voltage V3 output by the detection circuit 6 in the frequency domain as described above also enables minimization of reduction in precision of measurement of the electric current I, for example, the reduction being due to the skin effect.

The electric current measurement method is still another one of the techniques disclosed herein. The electric current measurement method includes: detecting the magnetic field H at a position by using the magnetic field sensor 4 placed at the position in the shield 3 having the opening 37 for capturing the magnetic field H in the shield 3, the magnetic field H having been generated by the electric current I flowing through the conductor 9 (for example, Step S1 in FIG. 9); and detecting the electric current I on the basis of a detection result from the magnetic field sensor 4 (for example, Step S2 in FIG. 9). As described already, the magnetic field sensor 4 includes the magnetic field sensor 41 and the magnetic field sensor 42. This electric current measurement method also enables, as described already, minimization of reduction in precision of measurement of the electric current I, the reduction being due to the skin effect.

**Claims**

1. An electric current sensor (1), comprising:

   a shield having an opening (37) for capturing a magnetic field (H) in the shield (3), the magnetic field (H) having been generated by an electric current (I) flowing through a conductor (9);
   a magnetic field sensor (4) that is placed at a position in the shield (3) and outputs a sensor voltage corresponding to the magnetic field (H) at the position; and
   a detection circuit (6) that is placed outside the shield (3) and detects the electric current (I) on the basis of the sensor voltage from the magnetic field sensor (4), wherein
   the magnetic field sensor (4) includes:

      a first magnetic field sensor (41) to detect low-frequency magnetic fields; and
      a second magnetic field sensor (42) to detect high-frequency magnetic fields;

   the first magnetic field sensor (41) is placed nearer to the opening (37) than the second magnetic field sensor (42), and
   the second magnetic field sensor (42) is placed farther from the opening (37) than the first magnetic field sensor (41).

2. The electric current sensor (1) according to claim 1, wherein

   the first magnetic field sensor (41) is placed in a near region near the conductor (9),
   the second magnetic field sensor (42) is placed in a far region far from the conductor (9),
   the near region is a region where the magnetic field (H) is changed in intensity according to whether or not the skin effect in the conductor (9) is present, and
   the far region is a region where the magnetic field (H) is not changed in intensity according to whether or not the skin effect in the conductor (9) is present.

3. The electric current sensor (1) according to claim 1 or 2, wherein the detection circuit (6)

   determines, on the basis of the sensor voltage from the magnetic field sensor (4), whether or not the skin effect in the conductor (9) has occurred,
   detects the electric current (I) on the basis of a sensor voltage (V1) from the first magnetic field sensor (41) when the skin effect in the conductor (9) has not occurred, and
   detects the electric current (I) on the basis of a sensor voltage (V2) from the second magnetic field sensor (42) when the skin effect in the conductor (9) has occurred.

4. The electric current sensor (1) according to claim 3, wherein

   the first magnetic field sensor (41) further detects high-frequency magnetic fields,
   each of the first magnetic field sensor (41) and the second magnetic field sensor (42) includes a coil sensor to detect high-frequency magnetic fields, and
   the detection circuit (6) determines, on the basis of a sensor voltage (V12) from the coil sensor of the first magnetic field sensor (41) and a sensor voltage (V2) from the coil sensor of the second magnetic field sensor (42), whether or not the skin effect in the conductor (9) has occurred.

5. The electric current sensor (1) according to claim 4, wherein the detection circuit (6) determines, on the basis of a ratio (R) between the sensor voltage (V12) from the coil sensor of the first magnetic field sensor (41) and the sensor voltage (V2) from the coil sensor of the second magnetic field sensor (42), whether or not the skin effect in the conductor (9) has occurred.

6. An electric current sensor (1) comprising:

   a shield (3) having an opening (37) for capturing a magnetic field (H) in the shield (3), the magnetic field (H) having been generated by an electric current (I) flowing through a conductor (9);
   a magnetic field sensor (4) that is placed at a position in the shield (3) and outputs a sensor voltage corresponding to the magnetic field (H) at the position;
   a detection circuit (6) that is placed outside the shield (3) and detects the electric current (I) on the basis of the sensor voltage from the magnetic field sensor (4); and
   a movement mechanism (7) that moves the magnetic field sensor (4), wherein
   the magnetic field sensor (4) includes:

      a first magnetic field sensor (41) that is placed near the opening (37) and is to detect high-frequency magnetic fields; and
      a second magnetic field sensor (42) to detect high-frequency magnetic fields, and

   the movement mechanism (7) moves the second magnetic field sensor (42) between a position near the opening (37) and a position far from the opening (37).

7. The electric current sensor (1) according to claim 6, wherein

   the detection circuit (6) determines, on the basis of the sensor voltage from the magnetic field sensor (4), whether or not the skin effect in the conductor (9) has occurred, and
   the movement mechanism (7) moves the second magnetic field sensor (42) so that when the skin effect in the conductor (9) has not occurred, the second magnetic field sensor (42) is placed near the opening (37), and when the skin effect in the conductor (9) has occurred, the second magnetic field sensor (42) is placed far from the opening (37).

8. An electric current measurement device (100) comprising:

   a shield (3) having an opening (37) for capturing a magnetic field (H) in the shield (3), the magnetic field (H) having been generated by an electric current (I) flowing through a conductor (9);
   a magnetic field sensor (4) that is placed at a position in the shield (3) and outputs a sensor voltage corresponding to the magnetic field (H) at the position;
   a detection circuit (6) that is placed outside the shield (3) and generates, on the basis of the sensor voltage from the magnetic field sensor (4), a detection voltage (V3) indicating a value of the electric current (I); and
   an external device (2) that is placed outside the shield (3) and corrects the detection voltage (V3) in a frequency domain.

9. The electric current measurement device (100) according to claim 8, wherein

   the sensor voltage undergoes a change due to the skin effect in the conductor (9),
   the detection voltage (V3) undergoes a change due to the change in the sensor voltage, and
   the external device (2) corrects the detection voltage (V3) so as to eliminate the change in the detection voltage (V3).

10. The electric current measurement device (100) according to claim 8 or 9, wherein the external device (2) includes:

   a waveform generation unit (221) configured to generate a waveform of the detection voltage (V3);
   a Fourier transform unit (222) configured to perform Fourier transform of the waveform of the detection voltage (V3);
   a correction unit (223) configured to correct a frequency component of the detection voltage (V3), the frequency component having been acquired by the Fourier transform; and
   an inverse Fourier transform unit (224) configured to perform inverse Fourier transform of the corrected frequency component of the detection voltage (V3).

11. An electric current measurement method comprising:

   detecting a magnetic field (H) at a position by using a magnetic field sensor (4) placed at the position in a shield (3) having an opening (37) for capturing the magnetic field (H) in the shield (3), the magnetic field (H) having been generated by an electric current (I) flowing through a conductor (9); and

detecting the electric current (I) on the basis of a detection result from the magnetic field sensor (4), wherein the magnetic field sensor (4) includes:

a first magnetic field sensor (41) to detect low-frequency magnetic fields; and
a second magnetic field sensor (42) to detect high-frequency magnetic fields,

the first magnetic field sensor (41) is arranged nearer to the opening (37) than the second magnetic field sensor (42), and
the second magnetic field sensor (42) is arranged farther from the opening (37) than the first magnetic field sensor (41).

FIG.1

## FIG.2

## FIG.3

# FIG.4

# FIG.5

# FIG.6

# FIG.7

# FIG.8

# FIG.9

# FIG.10

# FIG.11

# FIG.12

$$R = \frac{V2}{V12}$$

R0

N1 N2 N3 N4 N5 MEASUREMENT

# FIG.13

| MEASUREMENT | SKIN EFFECT |
|:---:|:---:|
| N1 | NO |
| N2 | YES |
| N3 | NO |
| N4 | NO |
| N5 | YES |

# FIG.14

```
        ┌─────────────┐
        │    START    │
        └──────┬──────┘
               │
               ▼
┌──────────────────────────────┐
│ DETECT MAGNETIC FIELD H USING │ ～S11
│ MAGNETIC FIELD SENSOR 41 AND  │
│   MAGNETIC FIELD SENSOR 42    │
└───────────────┬───────────────┘
                │
                ▼
┌──────────────────────────────┐
│ DETERMINE WHETHER OR NOT SKIN │
│ EFFECT IN CONDUCTOR 9 HAS     │ ～S12
│ OCCURED ON BASIS OF DETECTION │
│ RESULT FROM MAGNETIC FIELD    │
│ SENSOR 41 AND DETECTION       │
│ RESULT FROM MAGNETIC FIELD    │
│ SENSOR 42                     │
└───────────────┬───────────────┘
                │
                ▼
          ◇ S13
     HAS SKIN EFFECT              YES
     IN CONDUCTOR 9  ─────────────────┐
       OCCURRED?                      │
          │                           ▼
          │ NO                  ┌──────────────────┐ S15
          ▼     S14            │ DETECT ELECTRIC  │
┌──────────────────────────┐   │ CURRENT I ON BASIS│
│ DETECT ELECTRIC CURRENT I │   │ OF DETECTION      │
│ ON BASIS OF DETECTION     │   │ RESULT FROM       │
│ RESULT FROM MAGNETIC      │   │ MAGNETIC FIELD    │
│ FIELD SENSOR 41           │   │ SENSOR 42         │
└──────────────┬───────────┘   └─────────┬────────┘
               │                          │
               ◄──────────────────────────┘
               │
               ▼
        ┌─────────────┐
        │     END     │
        └─────────────┘
```

# FIG.15

# FIG.16

TO MOVEMENT MECHANISM 7

# FIG.17

START

HAS SKIN EFFECT
IN CONDCUTOR 9
OCCURRED?                    S21

NO

YES                    S22

PLACE MAGNETIC FIELD SENSOR 42 FAR
FROM OPENING 37

S23

PLACE MAGNETIC FIELD
SENSOR 42 NEAR
OPENING 37

S24

DETECT MAGNETIC FIELD H USING
MAGNETIC FIELD SENSOR 41 AND
MAGNETIC FIELD SENSOR 42

S25

DETECT ELECTRIC CURRENT I ON
BASIS OF DETECTION RESULT FROM
MAGNETIC FIELD SENSOR 41 AND
DETECTION RESULT FROM MAGNETIC
FIELD SENSOR 42

END

# FIG.18

# FIG.19

EP 4 722 737 A2

# FIG.20

VOLTAGE
V3

TIME

# FIG.21

COMPONENT
A3

FREQUENCY

FIG.22

FIG.23

# FIG.24

START

DETECT MAGNETIC FIELD H USING MAGNETIC FIELD SENSOR 4 — S31

GENERATE WAVEFORM ON BASIS OF DETECTION RESULT FROM MAGNETIC FIELD SENSOR 4 — S32

SUBJECT WAVEFORM TO FOURIER TRANSFORM — S33

CORRECT FREQUENCY COMPONENT — S34

SUBJECT CORRECTED FREQUENCY COMPONENT TO INVERSE FOURIER TRANSFORM — S35

DISPLAY WAVEFORM — S36

END

**EP 4 722 737 A2**

### Patent documents cited in the description

- JP 2014115114 A